# EUROPEAN PATENT APPLICATION

(11) **EP 1 508 906 A2**
(43) Date of publication of application: **23.02.2005**
(21) Application number: 04254930.3
(22) Date of filing: 17.08.2004
(51) Int. Cl.: H01G 4/10, H01L 21/02

(54) **Capacitor, method of manufacturing the same and memory device including the same**

(30) Priority: 18.08.2003 KR 2003056857
(71) Applicant: Samsung Electronics Co., Ltd., Suwon-si, Gyeonggi-do (KR)
(72) Inventor: Lee, Jung-hyun, c/o 106-803 Taeyoung Leisvill Apt., Yongin-si, Gyeonggi-do (KR); Seo, Bum-seok, Seoul (KR)
(74) Representative: Greene, Simon Kenneth

(57) **Abstract**

A capacitor of a semiconductor device and a method of manufacturing the same and a memory device including the capacitor are provided. The capacitor includes a lower electrode, a dielectric film, and an upper electrode. A first reaction barrier film is further formed between the lower electrode and the dielectric film. The dielectric film is an oxide film (LaO) that includes a lanthanide element, and a second reaction barrier film can further be formed between the upper electrode and the dielectric film. In a process of depositing an oxide film that includes a lanthanide element, impurities are removed by flowing vapor and then ozone over the oxide film. To control a reaction between the lower electrode and the dielectric film, the first reaction barrier film is a hafnium film or an aluminum film that includes positive ions with smaller radii than positive ions of the lanthanum oxide film (La₂O₃).

## Description

The present invention relates to a semiconductor device and a method of manufacturing the same, and more particularly, to a capacitor, a method of manufacturing the same and a memory device including the capacitor.

A lanthanum oxide (La₂O₃) can be used as a dielectric film in a capacitor of a semiconductor device.

When a lanthanum oxide film is deposited on a silicon layer, a silicate is formed in the capacitor as a result of a reaction between the lanthanum oxide film and silicon of the silicon layer. The formation of silicate results in lowering characteristics of the capacitor.

As the integration density of semiconductor devices increases, it is required to form capacitors having larger capacitance in a narrow region. The capacitance of a capacitor is proportional to a surface area of an electrode. Therefore, the capacitance of a capacitor can be increased by forming the electrode in three dimensions.

It is desirable that a thickness and a composition of a dielectric film are uniform even if the electrode of the capacitor has a complicated structure.

However, a conventional deposition method such as a chemical vapor deposition (CVD) method is not suitable for forming a dielectric film having a uniform thickness and composition on an electrode with a complicated structure due to process characteristics of the CVD method.

An atomic layer deposition (ALD) method for forming a thin film on a lower structure of a complicated structure has been introduced, in which a thin film with a desired composition can be deposited in a deep region of a complicated structure. This method provides a uniformity of thickness and composition of a thin film to some degree.

Therefore, the ALD method can be used for forming a dielectric film having a uniform thickness and composition on a capacitor electrode having a complicated structure.

The lanthanum oxide film can also be formed using the ALD method. However, there is a possibility of characteristic changes of the lanthanum oxide film resulting from absorption of water vapor (H₂O) when the lanthanum oxide is exposed to the air because lanthanides are hygroscopic.

That is, when forming the lanthanum oxide film using the ALD method after deposition of a lanthanum precursor layer, a large amount of water vapor can be absorbed by the lanthanum precursor layer during an oxidization process using water vapor (H₂O). In this case, electrical characteristics such as an ability of the lanthanum oxide film to prevent a leakage current can be degraded.

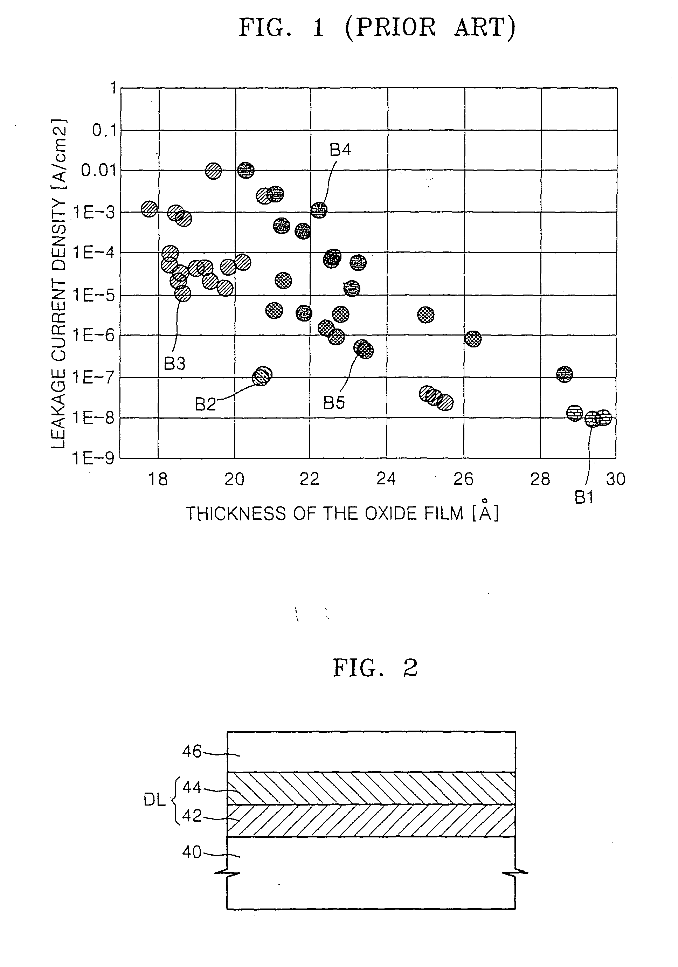

FIG. 1 is a graph illustrating the increase in the leakage current density when water vapor is used as an oxidation gas for forming a few oxide films such as the lanthanum oxide film using the ALD method. Reference character B1 represents a leakage current density of an aluminum oxide film formed to a thickness of 40 Å, and B2 represents that of a hafnium oxide film formed in a thickness of 45 Å. Reference character B3, B4, and B5 represent leakage currents of precursors La(tmhd)₃, La(N(Si(Me)₃)₂)₃, and La(iPrCp)₃, respectively.

According to an aspect of the present invention, there is provided a capacitor of a semiconductor device, comprising a lower electrode, a dielectric film, and an upper electrode with a first reaction barrier film formed between the lower electrode and the dielectric film.

The dielectric film is an oxide film that includes a lanthanide element.

A second reaction barrier film can further be formed between the upper electrode and the dielectric film.

The first and second reaction barrier films are each a hafnium oxide film or an aluminum oxide film that includes positive ions with smaller radii than positive ions of the lanthanum oxide film (La₂O₃).

According to another aspect of the present invention, there is provided a method of forming a capacitor comprising forming a lower electrode, forming a first reaction barrier film on the lower electrode, forming a precursor layer that includes a metal element on the first reaction barrier film, forming an oxide film that includes a metal element by oxidizing the metal element of the precursor layer, drying the oxide film, and forming an upper electrode on the dried oxide film.

The lower electrode is a silicon electrode doped with a conductive dopant, and the upper electrode is a titanium nitride film.

A second reaction barrier film can further be formed between the dried oxide film and the upper electrode, and the lower electrode and the upper electrode can be silicon electrodes doped with a conductive dopant or titanium nitride films.

An exhaust process may be performed after forming the precursor layer, after forming the oxide film, and after drying the oxide film.

The forming the oxide film may comprise flowing water vapor over the precursor layer to firstly oxidize the precusor layer.

The forming the oxide film may further comprises supplying ozone over the firstly oxidized precursor layer to secondly oxidize the firstly oxidized precursor layer.

The firstly and secondly oxidation processes may be repeated.

The oxide film is dried by flowing ozone over the oxide film.

The first and second reaction barrier films can each be a hafnium oxide film or an aluminum oxide film that includes positive ions with smaller radii than positive ions of the dielectric film.

According to yet another aspect of the present invention, there is provided a semiconductor memory device having a capacitor connected to a transistor, wherein the capacitor includes a lower electrode, a dielectric film, an upper electrode and a first reaction barrier film interposed between the lower electrode and the dielectric film.

Since, the capacitor according to the present invention prevents an unwanted reaction between the lanthanum oxide film used as the dielectric film and the lower electrode, and prevents inclusion of a large amount of vapor in the lanthanum oxide while forming the oxide film, degradation of electrical characteristics of the lanthanum oxide, that is, the capacitor, are prevented, thereby increasing the reliability of the semiconductor memory device that includes the capacitor.

The present invention provides a capacitor that inhibits an unwanted reaction between a dielectric film and a lower electrode on which the dielectric film is formed, and prevents a degradation of electrical characteristics of a dielectric film formed by atomic layer deposition (ALD) by preventing the dielectric film from absorbing a large amount of water vapor.

The present invention also provides a method of manufacturing the capacitor.

The present invention also provides a semiconductor memory device including the capacitor.

The above and other features and advantages of the present invention will become more apparent by describing in detail exemplary embodiments thereof with reference to the attached drawings in which:
FIG. 1 is a graph illustrating leakage current density with respect to thickness of a dielectric film of a conventional capacitor for several types of dielectric film;
FIG. 2 is a cross-sectional view of a capacitor according to an exemplary embodiment of the present invention;
FIG. 3 is a graph illustrating a leakage current density of the capacitor depicted in FIG. 2 with respect to a voltage applied to the capacitor;
FIG. 4 is a block diagram for describing each operation of manufacturing a capacitor depicted in FIG. 2;
FIG. 5 is a block diagram for describing a second operation of manufacturing a capacitor depicted in FIG. 4; and
FIG. 6 is a cross-sectional view of a semiconductor device having the capacitor depicted in FIG. 2.

The present invention will now be described more fully with reference to the accompanying drawings in which exemplary embodiments of the present invention are shown. However, this invention may be embodied in many different forms and should not be construed as being limited to the embodiments set forth herein. Rather, these embodiments are provided so that this disclosure will be thorough and complete and fully convey the concept of the invention to those skilled in the art. In the drawings, the thicknesses of layers and regions are exaggerated for clarity.

A capacitor according to an exemplary embodiment of the present invention will now be described.

FIG. 2 is a cross-sectional view of a capacitor according to an exemplary embodiment of the present invention.

Referring to FIG. 2, the capacitor includes a lower electrode 40, a dielectric film DL, and an upper electrode 46. The lower electrode 40 is a silicon electrode doped with a conductive dopant and can be formed of titanium nitride (TiN). The dielectric film DL includes a first dielectric film 42 and a second dielectric film 44. The first dielectric film 42 prevents an unwanted reaction between the lower electrode 40 and the second dielectric film 44, that is, it prevents silicate formation. The first dielectric film 42 is preferably formed of a dielectric film including positive ions with smaller radii than those in the second dielectric film 44, such as a hafnium oxide film (HfO₂) or an aluminum oxide film (Al₂O₃). The thickness of the first dielectric film 42 can be about 2 nm, but is preferably thinner than the second dielectric film 44. The second dielectric film 44 is preferably formed of an oxide film that includes a lanthanide element, such as lanthanum oxide (LaO). The thickness of the second dielectric film 44 is preferably 2 to 10 nm, but may thicker or thinner than this. The upper electrode 46 is preferably a titanium nitride (TiN) electrode, but can also be a silicon electrode doped with a conductive dopant. However, in the latter case, a reaction barrier film that prevents a silicate reaction between the upper electrode 46 and the second dielectric film 44 can further be formed therebetween. The upper electrode 46 and the lower electrode 40 can be formed of the same material.

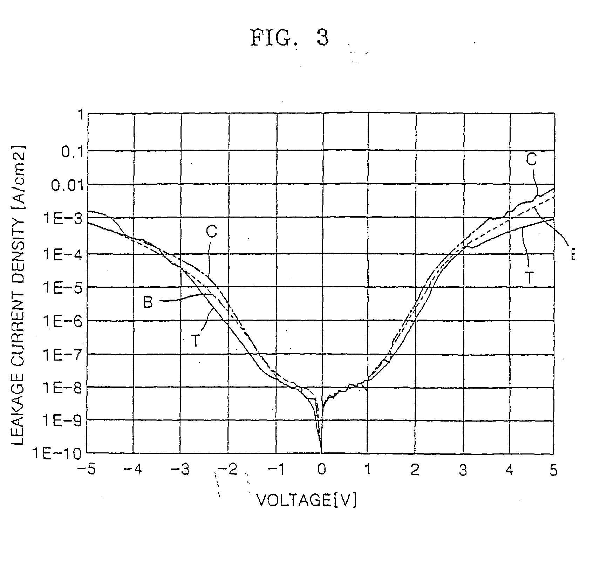

FIG. 3 is a graph illustrating a leakage current density with respect to a voltage applied to the capacitor according to an exemplary embodiment of the present invention. In FIG. 3, graphs T, B, and C represent leakage current densities of capacitors formed in an upper part, a lower part, and a middle part of a wafer respectively when the wafer having the capacitors depicted in FIG. 2, is vertically positioned.

Referring to the graphs T, B, and C, the capacitors formed on the upper, lower, and middle parts of the wafer show little differences in their leakage current densities, and the leakage current densities are lower than 10⁻⁷A/cm² within a driving voltage.

From the graphs T, B, and C, it also is seen that the leakage current characteristics of the capacitors formed on all regions of the wafer are also superior as in the leakage current characteristics of the capacitors formed on the upper, lower, and middle parts of the wafer.

A method of manufacturing the capacitor depicted in FIG. 2 according to an exemplary embodiment of the present invention will now be described.

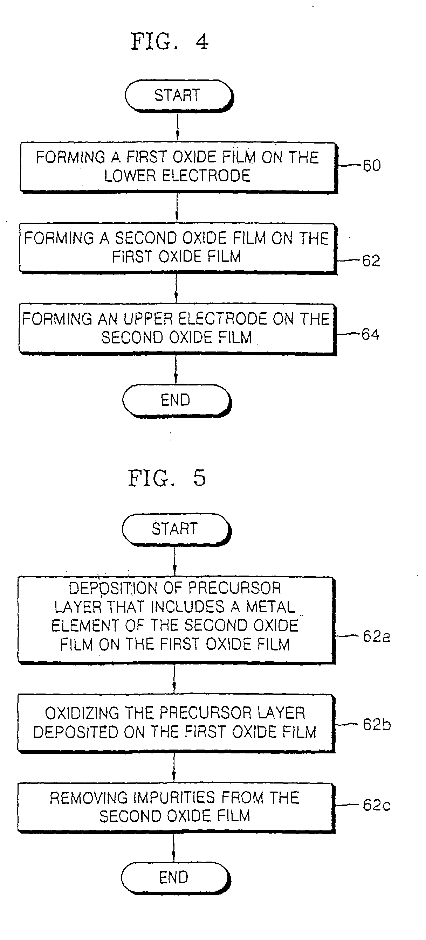

Referring to FIG. 4, the method of manufacturing the capacitor includes first through third operations 60, 62, and 64.

In the first operation 60, a first oxide film is formed on a lower electrode. The lower electrode is preferably a silicon electrode doped with a conductive dopant, but the lower electrode can also be another conductive electrode such as a titanium nitride electrode. The first oxide film is used partly as a dielectric film of a capacitor, but mainly as a reaction barrier film that prevents an unwanted reaction between a second oxide film which will be formed later and the lower electrode. Therefore, it is desirable that the dielectric film is formed without a component that can react with a component, i.e., silicon, included in the lower electrode. The thickness of the first oxide film is preferably formed to about 2 nm, which is thinner than the second oxide film, but may also thicker or thinner than 2 nm. Since the first oxide film is formed to a thickness of a few nano meters, it is preferable that the first oxide film is formed using an ALD method in which thickness and composition can be controlled instead of a widely used thin film deposition method such as a conventional CVD method. The first oxide film can be formed with a single layer film, but can also be formed with a double layer film. The first oxide film can be formed of a hafnium oxide film and/or an aluminum oxide film.

In the second operation, a second oxide film is formed on the first oxide film. The second oxide film performs the same function as the second dielectric film 44. Therefore, it is preferable that the second oxide film is an oxide film including positive ions with larger radii than those in the first oxide film. It is desirable that the second oxide film is formed of an oxide film that includes a lanthanide element such as a lanthanum oxide film (LaO). Preferably, the second oxide film is formed to a thickness of a few nano meters like the first oxide film. However, the second oxide film is formed to the same thickness or thicker than the first oxide film. Since the second oxide film is also formed to a thickness of a few nano meters, it is preferably formed by an ALD method as opposed to a conventional thin film deposition method. The forming of the second oxide film using the ALD method will be described later.

In the third operation 64, an upper electrode is formed on the second oxide film. The upper electrode is a titanium nitride electrode or can be a silicon electrode doped with a conductive dopant.

Referring to FIG. 5, the second operation 62 can further be divide into three sub-operations 62a, 62b, and 62c. A detailed method of forming the second oxide film using an ALD method is performed in the sub-operations 62a, 62b, and 62c. The second oxide film is a lanthanum oxide film (La₂O₃).

More specifically, in the first sub-operation 62a, a precursor that includes a metal component (La) of the second oxide film, such as (La(tmhd)₃, La(N(Si(Me)₃)₂)₃, or La(iPrCp)₃, is deposited on the first oxide film. Then, the precursor layer is formed by performing a first exhaust process, and remaining precursors are removed form the reaction chamber.

In the second sub-operation 62b, the precursor layer is oxidized. More specifically, an oxidation gas such as water vapor is supplied to the reaction chamber after the first exhaust process. Then, the second oxide film, i.e., the lanthanum oxide film is formed on the lower electrode through a substitution reaction between the oxidation gas and the precursor layer, that is, oxidation of the precursor layer. Then, an unreacted portion of the oxidation gas in the reaction chamber is removed by performing a second exhaust process.

In the third sub-operation 62c, impurities are removed form the second oxide film. More specifically, excess water vapor included in the second oxide film is removed by supplying ozone to the reaction chamber after performing the second exhaust process. Then, a third exhaust process is performed to remove remaining ozone from the reaction chamber.

The third sub-operation 62c is regarded as a drying process from the point of view that the water vapor included in the second oxide film is removed.

The third sub-operation 62c is also regarded as a second oxidation process because the precursor layer can further be oxidized by the supplied ozone while removing impurities.

Table 1 illustrates whether a second oxide film is formed, whether water vapor remains in the second oxide film, and a leakage current density in the second oxide film according to the oxidation process used to form the second oxide film on the lower electrode using an ALD method.

**[Table 1]**

| Oxidation Process | O₃ | H₂0 | H₂0-->O₃ | O₃-->H₂0 |
|---|---|---|---|---|
| Film formation | no | yes | yes | no |
| water vapor (H₂O) inclusion | - | yes | no | - |
| leakage current density (A/cm²) | - | 10⁻¹ | 10⁻⁷ | |

Referring to Table 1, the second oxide film is not formed on the lower electrode when ozone is used as the oxidation gas or when water vapor (H₂O) is supplied to the reaction chamber after supplying the ozone.

When the water vapor (H₂O) is used as the oxidation gas, the second oxide film is formed on the lower electrode. However, the water vapor (H₂O) is included in the formed second oxide film and the leakage current density is as high as 10⁻¹ A/cm₂.

On the other hand, when ozone is supplied to the chamber after supplying the water vapor (H₂O) according to the method of manufacturing the capacitor according to the present invention, not only is the second oxide film formed on the lower electrode, but the water vapor (H₂O) does not remain in the formed second oxide film and the leakage current density is as low as 10⁻⁷ A/cm₂.

A semiconductor memory device including the capacitor depicted in FIG. 2 according to an exemplary embodiment of the present invention will now be described.

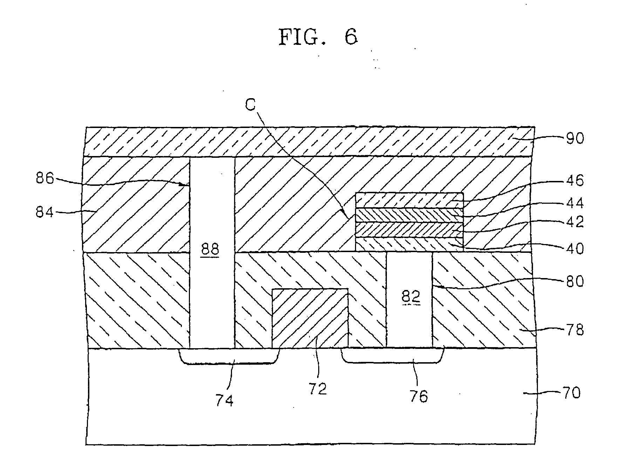

Referring to FIG. 6, the memory device includes first and second doped regions 74 and 76 doped with a conductive dopant in a substrate 70. The first and second doped regions 74 and 76 are separated by a predetermined distance. The first region 74 is a source region and the second region 76 is a drain region. A channel region is formed between the two regions 74 and 76 on the substrate 70, and a gate stack 72 is disposed on the channel region. The gate stack 72 turns the channel region on or off according to a voltage applied to the gate stack 72. The gate stack 72 includes a gate insulating film (not shown) and a gate conductive layer (not shown). The substrate 70, the first and second regions 74 and 76, and the gate stack 72 constitute a MOSFET. A first inter-layer insulating layer 78 that covers the gate stack 72 and part of the substrate 70, and a first contact hole 80 that exposes the second region 76 is formed in the first inter-layer insulating layer 78. The first contact hole 80 is filled with a first conductive plug 82 such as polysilicon doped with a conductive dopant. A capacitor C is formed on the first conductive plug 82 and the first inter-layer insulating layer 78 and covers the entire surface of the first conductive plug 82. The capacitor C is preferably the same as the capacitor C depicted in FIG. 2. Therefore, descriptions of detailed structure and performances are omitted. The lower electrode 40 and the first conductive plug 82 are preferably formed of the same conductive material but can also be formed of different conductive materials. A second inter-layer insulating layer 84 is formed on the capacitor C and the first inter-layer insulating layer 78 and covers the capacitor C. A second contact hole 86 that exposes the first region 74 is formed in the first inter-layer insulating layer 78 and the second inter-layer insulating layer 84. The second contact hole 86 is filled with a second conductive plug 88. The second conductive plug 88 is preferably formed of polysilicon doped with a conductive dopant, but can also be formed of a different conductive material. A conductive layer 90 is formed on the second conduction plug 88 and the second inter-layer insulating layer 84 and covers an entire surface of the second conductive plug 88. The conductive layer 90 is a bit line and cross to the gate stack 72. The conductive layer 90 and the second conductive plug 88 are preferably formed of the same conductive material but can also be formed of different conductive materials.

Since the memory device described heretofore is equipped with the capacitor C depicted in FIG. 2, data stored in the capacitor C can be maintained for a long time in a normal state, thereby increasing reliability of the memory device.

The capacitor according to the exemplary embodiment of the present invention includes a reaction barrier film that prevents an unwanted reaction between an oxide film which includes a lanthanide element and is used as a dielectric film, and a lower and/or an upper electrode that includes silicon. Accordingly, electrical degradation of the capacitor due to silicate formation as a result of a reaction between lanthanide in the oxide film and the silicon can be avoided. In the process of forming the oxide film using an ALD method, water vapor is completely removed by ozone after forming the oxide film. That is, the oxide film is completely dried. Thus, electrical degradation of the capacitor due to an inclusion of water vapor in the oxide film is prevented. A memory device including the capacitor according to the present invention can store data for a long time without loss, thereby increasing the reliability of the memory device.

In the capacitor according to the present invention, the first dielectric film can also be a non-oxide film that can prevent a reaction between an oxide film and an upper and/or lower electrode that includes silicon. Also, the upper and lower electrodes can be formed of a material that does not include silicon, and the dielectric film can be replaced by lanthanide oxide film.

While the present invention has been particularly shown and described with reference to exemplary embodiments thereof, it will be understood by those of ordinary skill in the art that various changes in form and details may be made therein without departing from the scope of the present invention as defined by the following claims.

## Claims

1. A capacitor of a semiconductor device comprising:
a lower electrode;
a dielectric film on the lower electrode;
an upper electrode on the dielectric film; and
a first reaction barrier film that prevents a reaction between the lower electrode and the dielectric film, interposed between the lower electrode and the dielectric film.

2. The capacitor of claim 1, wherein the lower electrode is a silicon electrode doped with a conductive dopant.

3. The capacitor of claim 1 or 2, wherein the first reaction barrier film is one of a hafnium oxide film and an aluminum oxide film that includes positive ions with smaller radii than positive ions of the dielectric film.

4. The capacitor of any preceding claim, wherein the dielectric film is an oxide film that includes a lanthanide element.

5. The capacitor of claim 4, wherein the oxide film that includes the lanthanide element is La₂O₃ film.

6. The capacitor of any preceding claim, wherein the upper electrode is a titanium nitride film.

7. The capacitor of any preceding claim, further comprising a second reaction barrier film between the upper electrode and the dielectric film wherein the upper electrode is a silicon electrode doped with a conductive dopant.

8. The capacitor of claim 7, wherein the second reaction barrier film is one of a hafnium oxide film and an aluminum oxide film that includes positive ions with smaller radii than positive ions of the dielectric film.

9. A method of forming a capacitor comprising:
forming a lower electrode;
forming a first reaction barrier film on the lower electrode;
forming a precursor layer that includes a metal element on the first reaction barrier film;
forming an oxide film that includes the metal element by oxidizing the precursor layer;
drying the oxide film; and
forming an upper electrode on the dried oxide film.

10. The method of claim 9 further comprising, before forming the upper electrode, forming a second reaction barrier film on the dried oxide film.

11. The method of claim 10, wherein the lower electrode and the upper electrode are each one of a silicon electrode doped with a conductive dopant and a titanium nitride film.

12. The method of claim 10, wherein the second reaction barrier film is one of a hafnium oxide film and an aluminum oxide film that includes positive ions with smaller radii than positive ions of the dielectric film.

13. The method of claim 9, 10, 11 or 12 wherein the lower electrode is formed of a silicon electrode doped with a conductive dopant, and the upper electrode is formed of a titanium nitride film.

14. The method of any of claims 9 to 13, wherein the lower and upper electrodes are a titanium nitride film.

15. The method of any of claims 9 to 14, wherein an exhaust process is performed after forming the precursor layer.

16. The method of any of claims 9 to 14, wherein an exhaust process is performed after forming the oxide film.

17. The method of any of claims 9 to 14, wherein an exhaust process is performed after drying the oxide film.

18. The method of any of claims 9 to 14, wherein the forming the oxide film comprises flowing water vapor over the precursor layer to firstly oxidize the precusor layer.

19. The method of claim 18, wherein the forming the oxide film further comprises supplying ozone over the firstly oxidized precursor layer to secondly oxidize the firstly oxidized precursor layer.

20. The method of claim 19, wherein, in forming the oxide film, the firstly and secondly oxidations are repeated.

21. The method of any of claims 9 to 20, wherein the metal element is a lanthanide element.

22. The method of any of claims 9 to 21, wherein drying the oxide film comprises flowing ozone over the oxide film.

23. The method of any of claims 9 to 22, wherein the first reaction barrier film is one of a hafnium oxide film and an aluminum oxide film that includes positive ions with smaller radii than positive ions of the dielectric film.

24. A semiconductor memory device including a capacitor connected to a transistor, wherein the capacitor is a capacitor according to any of claims 1 to 8.
